Europäisches Patentamt

European Patent Office

Office européen des brevets

(19)

(11) Veröffentlichungsnummer : **0 079 854**
**B1**

(12) EUROPÄISCHE PATENTSCHRIFT

(45) Veröffentlichungstag der Patentschrift :
07.08.85

(21) Anmeldenummer : 82810475.2

(22) Anmeldetag : 08.11.82

(51) Int. Cl.⁴ : **C 09 D 5/24, C 03 C 17/00,**
**H 01 B 1/02// H05K1/09,**
**H01G1/01, H05B3/12**

(54) Silberhaltige leitfähige Ueberzugsmassen.

(30) Priorität : 12.11.81 US 320245

(43) Veröffentlichungstag der Anmeldung :
25.05.83 Patentblatt 83/21

(45) Bekanntmachung des Hinweises auf die Patenterteilung : 07.08.85 Patentblatt 85/32

(84) Benannte Vertragsstaaten :
DE FR GB IT SE

(56) Entgegenhaltungen :
US-A- 3 832 527

(73) Patentinhaber : **CIBA-GEIGY AG**
**Postfach**
**CH-4002 Basel (CH)**

(72) Erfinder : **McGowan, Earsel, Jr.**
**1630 Park Avenue**
**Washington Pennsylvania 15301 (US)**

**Beschreibung**

Uebliche silberhaltige leitfähige Ueberzugsmassen bestehen im allgemeinen aus einem partikelförmigen Metall in einem Glasfrittensystem. Dieses konventionelle Silber- und Glassystem kann verschieden Elemente als Modifikatoren enthalten, um Eigenschaften wie die Bindungsstärke, Lötbarkeit und Abriebfestigkeit zu steigern. Schwefelhaltige Verbindungen, wie Silbersulfat, Kupfersulfat, Silbersulfid, um nur einige zu nennen, werden oft zugesetzt, um die Glassubstrate zu färben, wenn die genannten Zusammensetzungen darauf aufgetragen werden, d. h. um ein dunkles Aussehen zu erzeugen, wenn man den aufgetragenen Ueberzug durch das Glas betrachtet. Diese Zusammensetzungen werden auch in einem für das beabsichtigte Anwendungsgebiet geeigneten Träger dispergiert. Beispielsweise werden Träger auf Fichtenölbasis oft für Siebdruckanwendungen benützt.

Solche übliche Systeme haben eine Reihe von bestimmten Nachteilen. Einmal neigen auf übliche Art gefärbte leitfähige Ueberzüge dazu, chemisch zu reagieren, wenn sie in Berührung mit schwefelhaltigen Stoffen kommen, wie vulkanisiertem Gummi und verwandten Produkten, denen man oft in der Automobilindustrie begegnet. Beispielsweise können Fenstergummidichtungen beeinträchtigt werden. Aehnlich kann man oft eine unerwünschte Entfärbung der nicht-verbundenen Silberoberfläche beobachten. Wegen der genannten Schwierigkeiten ist es weit besser, ungefärbte Ueberzüge herzustellen, d. h. Ueberzüge, die lediglich ein strohfarbenes Aussehen vermitteln. Damit verliert man jedoch die ansprechende, unauffälligere dunkelbraune oder dunkelrotbraune Farbe von gefärbten Mischungen. Die grossen Mengen von Färbmitteln, die in der Regel in üblichen gefärbten Ueberzügen gebraucht werden, um die gewünschte Farbe zu erzeugen, begrenzen auch den damit erzielten Leitfähigkeitsgrad. Da die Konzentrationen an Färbemittel und Silber zueinander umgekehrt proportional sind, verringert somit der Zusatz von Färbmittel notwendigerweise den Anteil an verfügbarem Silberleiter. Schliesslich ist auch die Möglichkeit von unerwünschter Gelbildung mit verschiedenen Trägern zu bedenken. Rückgängigmachen oder Verhüten solch einer Gelbildung ist sowohl teuer wie zeitaufwendig. Demnach weisen die gefärbten wie die ungefärbten bisher bekannten Mischungen beschränkte Leistungscharakteristiken und verminderte Verwendungsmöglichkeiten auf.

Ein erster Gegenstand der vorliegenden Erfindung besteht darin, eine neue Klasse von silberhaltigen leitfähigen Ueberzügen bereitzustellen. Ferner geht es darum, solche leitfähige Ueberzüge bereitzustellen, die wesentlich verbesserte Leistungscharakteristiken, eine ausgezeichnete Flexibilität in bezug auf Eigenschaften und Anwendungsgebiete aufweisen und zudem die unerwünschten Zutaten der bisher bekannten Formulierungen nicht enthalten.

Es wurde nun gefunden, dass man mit Selen oder selenhaltigen Verbindungen anstelle der in gefärbten silberhaltigen leitfähigen Ueberzügen in der Regel vorhandenen schwefelhaltigen Verbindungen die Schwierigkeiten mit den bisher bekannten Formulierungen im wesentlichen überwindet. So zeigen solche leitende Ueberzüge eine dunkelbraune oder dunkelrotbraune Färbung, wenn man sie nach dem Einbrennen durch Glas betrachtet. Die dunkle Farbe ist ansprechend und unauffälliger, was besonders erwünscht ist, wenn solche Zusammensetzungen als Entfrosterleitungen in Autorücklichtern (Rückscheiben) verwendet werden. Zudem verringert sich durch den Ersatz der schwefelhaltigen Verbindungen die Möglichkeit der Gelierung auf ein Mindestmass. Da geringere Mengen an Selenverbindungen benötigt werden, um eine vergleichbare Färbung zu erzielen, führt dies zu einer grösseren Flexibilität in bezug auf den Leitfähigkeitsgrad. Da man nun grössere Silbermengen einschliessen kann, lässt sich eine höhere Leitfähigkeit erzielen. Mit dieser Flexibilität in bezug auf das Einstellen des elektrischen Widerstandes der leitenden Ueberzüge eröffnet sich ein weites Feld von Anwendungsmöglichkeiten. Beispielsweise kann man nun Rücklichter in grösserer Vielfalt herstellen. Schliesslich reagieren die erfindungsgemässen Zusammensetzungen chemisch nur in geringem Ausmass, wenn sie mit schwefelhaltigen Stoffen, wie vulkanisiertem Gummi, in Berührung kommen.

Die Erfindung betrifft somit silberhaltige leitfähige Ueberzugsmassen enthaltend Silbermetall, Glasfritte und organische Träger auf der Basis von Fichtenölen, Pflanzenölen, Mineralölen oder niedermolekularen Erdölfraktionen, dadurch gekennzeichnet, dass die Ueberzugsmassen noch eine Selenkomponente enthalten.

Das Silbermetall liegt in Partikelform vor, entweder als Flocken oder Pulver oder beides zusammen. Die Gegenwart von metallischem Silber ergibt einen kontinuierlichen Leiter für elektrischen Strom.

Für die erfindungsgemässen Massen kann jede übliche weich Glasfritte verwendet werden. In der Regel wird die Fritte so gemahlen, dass sie ein 44 μm-Sieb passiert. Hauptzweck der Fritte ist es, das Silber mit dem Substrat zu verbinden, ohne die Leitfähigkeit, d. h. den Silber-Silber-Austausch zu beeinträchtigen. Die Fritte kann aus jeder geeigneten Kombination von Metalloxiden bestehen. Typische geeignete und auch bevorzugte Oxide können ausgewählt werden aus den Oxiden von Zink, Blei, Silicium, Titan, Zirkon, Natrium, Bor, Lithium, Kalium, Calcium, Aluminium, Zinn, Vanadium, Molybdän, Magnesium, Eisen und Mangan. Entsprechend können verschiedene Fluoride in der Fritte vorkommen. Die Zusammensetzung des Ansatzes, die die genannten Oxide und Fluoride liefert, kann verschiedene Salze der oben genannten Metalle enthalten, wie Oxide, Carbonate, Sulfate, Nitrate und Fluoride. Die Bestandteile des Ansatzes werden so gewählt, dass vorbestimmte Fritteneigenschaften erzielt werden. Besonders bevorzugt sind Fritten, die Bleioxid, Siliciumdioxid und Boroxid enthalten.

Man stellt die Fritte her, indem man die Bestandteile des Ansatzes bei Temperaturen von etwa 900 bis 1 600 °C schmelzt und dann das geschmolzene Glas entweder unter Verwendung von Wasser oder durch Giessen der Schmelze zwischen zwei in entgegengesetzter Richtung drehenden, gekühlten Metallrollen abschreckt. In der Regel führt man das Schmelzen in einem Keramik- oder Platinschmelztiegel oder in einem geeignet ausgekleideten Ofen durch. Die erhaltenen Schnitzel, Klumpen oder Flocken der Fritte werden dann zu feinen Teilen gemahlen.

Die Selenkomponente besteht aus metallischem Selen oder einer selenhaltigen Verbindung. Geeignete selenhaltige Verbindungen sind Selenide und Selenate, wie Kupfer-, Zink-, Cadmium-, Blei-, Barium-, Quecksilber-, Antimon-, Arsen-, Nickel- und Kobaltselenide und Bariumselenat, ferner Schwefel-Selenid-Komplexe, wie Cadmium-Schwefelselenid, ferner Metall-Selenid-Komplexe, wie Cadmium-Aluminiumselenid, Zink-Indiumselenid, Kupfer-Chromselenid und Kupfer-Chrom-Selenchlorid. Für die erfindungsgemässen Ueberzugsmassen bevorzugt man als Selenkomponente Schwefel-Selen-Legierungen, insbesondere in Pigmentform, vor allem ein Cadmium-Schwefelselenid-Pigment.

Das Trägermaterial wählt man aufgrund der vorgesehenen Verwendung. Es ist wesentlich, dass der Träger die Teilchen hinreichend in Schwebe hält und beim Brennen der Zusammensetzung vollständig abbrennt. Man bevorzugt organische Träger, insbesondere solche auf Basis von Fichtenölen, Pflanzenölen, Mineralölen und niedermolekularen Erdölfraktionen. Die Trägerstoffe können durch viskose Harze, wie Vinylharze, Lösungsmittel und Filmbildner, wie Cellulosematerialien, modifiziert werden. Als Träger sind vor allem solche auf Fichtenölbasis bevorzugt.

Die leitfähigen Ueberzugsmassen enthalten 45 bis 90 Gew.-%, bevorzugt 50 bis 82 Gew.-% Silbermetall, 1,5 bis 25 Gew.-%, bevorzugt 2 bis 20 Gew.-% Glasfritte, 0,5 bis 15 Gew.-%, bevorzugt 1 bis 3 Gew.-% Selenkomponente und 5 bis 50 Gew.-%, bevorzugt 7 bis 22 Gew.-% Trägermaterial bezogen auf das Gewicht der Masse. Die resultierenden Massen sind im Wesen viskos, wobei die Viskosität von der Verarbeitungsmethode und der Endanwendung abhängt. Für Siebdruck geeignete Viskositäten betragen zwischen 10'000 bis 80'000, bevorzugt 35'000 bis 65'000 Centipoises (20 °C, Brookfield-Viskosimeter, Nr. 7 Spindel, 20 U.p.M.).

Den erfindungsgemässen Ueberzugsmassen können weitere Stoffe zugegeben werden, um beispielsweise Viskosität oder elektrischen Widerstand zu verändern oder um Eigenschaften wie die Bindungsstärke, Lötbarkeit und Abriebfestigkeit zu verbessern. Typische Zusätze sind Wismut oder wismuthaltige Verbindungen für die Bindungsstärke und verbesserte Lötbarkeit, ferner widerstandsfähige Stoffe wie Zirkonoxid zur Verbesserung der Abriebfestigkeit, Schwebemittel, wie Isostearinsäure, und Quarzglas und andere Kieselerdeprodukte, um die Viskosität zu verändern. Es ist auch möglich, einen Teil des Gesamtsilbers durch feinteilige Metalle höheren Widerstandes zu ersetzen, um so, falls erwünscht, die Gesamtleitfähigkeit des leitenden Ueberzuges zu vermindern. Solche Metalle sind beispielsweise Nickel, Kupfer und Nickel-Chrom.

Die leitfähigen Ueberzugsmassen stellt man her, indem man die festen Stoffe mischt, die flüssigen Bestandteile zufügt, und das Ganze innig mischt oder knetet, um eine gleichmässige, dicke Paste zu bilden. Die Paste wird dann weiter dispergiert mittels einer gewöhnlichen Maschine, wie einer Dreirollenmühle, oder eines Dispergators, wie einer Cowles- oder Morehous-Mühle.

Die erfindungsgemässen Ueberzugsmassen können auf verschiedene Substrate, insbesondere auf Glas, aufgetragen werden. Methoden zum Auftragen der leitfähigen Ueberzugsmassen sind dem Fachmann geläufig. Die dispergierten Massen können durch Techniken wie Siebdruck, Abziehen, Sprühen, Streichen oder Walzen aufgetragen werden. Zur Auftragung der Ueberzugsmasse auf Glassubstrate bevorzugt man Siebdruck. Der aufgetragene Ueberzug wird dann eingebrannt, um das metallische Silber auf das Glassubstrat zu binden. Die Einbrenntemperatur lässt sich aufgrund der Gutbrandtemperatur der Fritte bestimmen. Für Automobilzwecke jedoch entspricht die Temperatur dem Glasabschreckzyklus, d. h. 630 bis 760 °C. Einbrenntemperaturen für Nicht-Glasanwendungen liegen in der Regel bei 450 bis 875 °C. Wenn mehr als ein leitfähiger Ueberzug aufgetragen werden muss, kann man einfach die erste Schicht trocknen lassen, eine zweite Schicht auftragen und dann den gesamten Ueberzug einbrennen.

Der gebrannte Ueberzug ergibt einen kontinuierlichen Leiter für elektrischen Stom. Er zeigt eine dunkelbraune oder dunkelrote Farbe, wenn man ihn durch Glas betrachtet und ergibt ein ansprechendes, unaufdringliches Muster. Die Färbung ist am besten sichtbar, wenn man den Ueberzug auf Floatglas aufträgt, d. h. auf Glas, das auf einer Zinnmetall-Schmelze gebildet wurde. Wie bereits erwähnt, eignen sich die erfindungsgemässen leitfähigen Ueberzüge für eine Vielzahl von Anwendungen. So können sie als Enteisungsheizelemente für Rückscheiben gebraucht werden, ferner als Heizelemente für Wärmeböden, als leitfähige Elemente für Tastschalttafeln, für gedruckte Schaltungen in der Elektronik, und zur Herstellung von elektronischen Bestandteilen, wie Widerständen und Kondensatoren.

Die folgenden Beispiele erläutern die Erfindung. Teile bedeuten Gewichtsteile, wenn nicht anders vermerkt.

Beispiel 1

Zur Herstellung der leitfähigen Ueberzugsmassen A und B werden die folgenden Stoffe eingesetzt :

| | Teile | |
|---|---|---|
| | A | B |
| Silberpulver | 80,67 | 72,00 |
| Glasfritte (1) | 2,56 | 8,74 |
| Glasfritte (2) | — | 0,87 |
| Selenkomponente (3) | 3,00 | 1,70 |
| Träger (4) | 10,08 | — |
| Träger (5) | — | 14,06 |
| $Bi_2O_3$ | — | 0,43 |
| Netzmittel (6) | 1,02 | — |
| Antigelierungsmittel (7) | 1,32 | 1,29 |
| Isostearinsäure | 1,35 | 0,91 |

1) Glasfritte

| | Teile |
|---|---|
| PbO | 78,2 |
| $SiO_2$ | 11,6 |
| $B_2O_3$ | 10,2 |

2) Glasfritte

| | Teile |
|---|---|
| PbO | 38,8 |
| $SiO_2$ | 5,4 |
| $H_3BO_3$ | 11,6 |
| $Bi_2O_3$ | 28,7 |
| $Li_2CO_3$ | 11,6 |
| $Na_2CO_3$ | 3,9 |

3) Cadmium-Schwefelselenid-Pigment × 3450® (Ciba-Geigy)

4) Träger

| | Teile |
|---|---|
| Fichtenöl | 73,9 |
| Aethylcellulose | 1,5 |
| Fliessmodifikator (*) | 16,8 |
| Vinylharz (**) | 0,3 |
| Aethylenglykol | 7,5 |

(*) ABALYN® (Hercules, Methylester von Kolophonium
(**) BAKELITE VINYL BUTYRAL XYSG® (UNION CARBIDE)

5) Träger

| | Teile |
|---|---|
| Fichtenöl | 73,46 |
| Lösungsmittel (*) | 13,70 |
| Aethylcellulose | 2,28 |
| Harz (**) | 7,22 |
| Fliessmodifikator | 0,34 |

(*) VARSOL® (EXXON, Kohlenwasserstoffgemisch)
(**) PICCOLASTIC A-25 und A-75® (Hercules, Polystyrolharze)

6) BRI-J92® (ICI, Polyoxyäthylenoleyläther)

7) BYKANOL-N® (Mallinckrodt, basiert auf Ketoxim und Aminosalzen von Phosphatestern).

Die genannten festen und flüssigen Stoffe werden zu dicken, gleichmässigen Pasten vermischt. Die Pasten werden dann mittels einer Dreiwalzenmühle dispergiert. Die so erhaltenen Pasten haben Brookfield-Viskositäten von 57'000 bzw. 40'000 Centipoises bei 20 °C.

Die Pasten werden darauf mittels Siebdruck auf Floatglas zu einem Gittermuster von 56,69 cm Länge und 0,076 2 cm Breite aufgetragen. Der Ueberzug wird während 4,5 Minuten bei 610 °C eingebrannt, wobei ein dunkelbraunes Gitter von metallischem Silber entsteht, wenn man durch das Glas hindurchschaut. Auf der entgegengesetzten Seite des Silberüberzuges ist keine Färbung vorhanden. Die Widerstände der Gittermuster betragen 33,22 Ohm/cm bzw. 105,16 Ohm/cm (Gemessen auf einem Fluke 8 000 A Ohmmeter).

Beispiel 2

Analog zu Beispiel 1 werden die Ueberzugsmassen A bis L hergestellt. Die einzelnen Bestandteile sind in Tabelle 1 aufgeführt. Die verschiedenen Formulierungen werden wie in Beispiel 1 auf Glas aufgetragen und zeigen gute Viskositäten, elektrische und färberische Eigenschaften.

(Siehe Tabelle 1 Seite 6 f.)

Tabelle 1

| | A Teile | B Teile | C Teile | D Teile | E Teile | F Teile | G Teile | H Teile | I Teile | J Teile | K Teile | L Teile |
|---|---|---|---|---|---|---|---|---|---|---|---|---|
| Silberpulver | 72,00 | 72,00 | 72,00 | 72,00 | 72,00 | 70,85 | 60,41 | 80,67 | 71,2 | 58,7 | 79,0 | 79,0 |
| Glasfritte (1) | 8,81 | 9,60 | 8,73 | 9,26 | 10,03 | 8,60 | 18,73 | 1,80 | 6,3 | 18,3 | 1,8 | 3,4 |
| Glasfritte (2) | 0,88 | 0,88 | 0,87 | 0,87 | - | 0,90 | - | - | - | - | - | - |
| Selenkomponente (3) | 1,61 | 0,40 | 1,61 | 1,61 | 1,71 | 1,70 | - | - | 1,7 | 1,9 | 3,7 | 2,0 |
| Selenpulver | - | - | - | - | - | - | 2,00 | 3,76 | - | - | - | - |
| $Bi_2O_3$ | 0,44 | 0,44 | - | - | - | 0,40 | - | - | - | - | - | - |
| Kieselerdefüller | - | - | - | - | - | - | 0,44 | - | 0,6 | 0,4 | - | - |
| Träger (4) | 14,06 | 14,06 | 14,06 | 14,06 | 14,06 | 15,07 | - | 10,08 | - | - | 11,4 | 11,4 |
| Träger (5) | - | - | - | - | - | - | 16,14 | - | - | 18,2 | - | - |
| Träger (8) | - | - | - | - | - | - | - | - | 17,8 | - | - | - |
| Netzmittel (6) | - | - | - | - | - | - | - | 1,02 | - | - | 1,1 | 1,1 |
| Antigelierungsmittel (7) | 1,29 | 1,29 | 1,29 | 1,29 | 1,29 | 1,45 | 1,26 | 1,32 | 1,5 | 1,4 | 1,5 | 1,5 |
| Isostearinsäure | 0,91 | 0,91 | 0,91 | 0,91 | 0,91 | 1,03 | 1,02 | 1,35 | 0,9 | 1,0 | 1,5 | 1,6 |

(1), (2), (3), (4), (5), (6), (7) wie in Beispiel 1

| | Teile |
|---|---|
| Fichtenöl | 65,7 |
| Lösungsmittel* | 13,7 |
| Aethylcellulose | 2,2 |
| Fliessmodifikator* | 0,7 |
| Aethylenglykol | 0,05 |
| Harz* | 17,65 |

* wie in Beispiel 1

**0 079 854**

**Patentansprüche**

1. Leitfähige Ueberzugsmassen, enthaltend 45 bis 90 Gew.-% Silbermetall in Partikelform, 1,5 bis 25 Gew.-% Glasfritte und 5 bis 50 Gew.-% organischer Träger auf der Basis von Fichtenölen, Pflanzenölen, Mineralölen oder niedermolekularen Erdölfraktionen bezogen auf das Gewicht der Masse, dadurch gekennzeichnet, dass die Ueberzugsmassen noch 0,5 bis 15 Gew.-% Selenkomponente enthalten.

2. Ueberzugsmassen gemäss Anspruch 1, worin die Glasfritte aus einer Kombination von Metalloxiden besteht.

3. Ueberzugsmassen gemäss Anspruch 1, worin die Glasfritte aus einer Kombination von Metalloxiden besteht, die aus der Gruppe von Zink-, Blei-, Silicium-, Titan-, Zirkon-, Natrium-, Bor-, Lithium-, Kalium-, Calcium-, Aluminium-, Zinn-, Vanadium-, Molybdän-, Magnesium-, Eisen- und Manganoxiden ausgewählt sind.

4. Ueberzugsmassen gemäss Anspruch 1, worin die Glasfritte aus Bleioxid, Siliciumdioxid und Boroxid besteht.

5. Ueberzugsmassen gemäss Anspruch 1, worin die Selenkomponente metallisches Selen, ein Selenid, Selenat, Schwefel-Selenid-Komplex oder Metall-Selenidkomplex ist.

6. Ueberzugsmassen gemäss Anspruch 1, worin die Selenkomponente ein Cadmium-Schwefelselenid-Pigment ist.

7. Ueberzugsmassen gemäss Anspruch 1, enthaltend 50 bis 82 Gew.-% Silbermetall, 2 bis 20 Gew.-% Glasfritte, 1 bis 3 Gew.-% Selenkomponente und 7 bis 22 Gew.-% Trägermaterial, bezogen auf das Gewicht der Masse.

8. Verwendung der Ueberzugsmassen gemäss Anspruch 1 zum Auftragen auf Glassubstrate.

**Claims**

1. A conductive coating composition comprising from 45 to 90 % by weight of silver in particulate form, from 1.5 to 25 % by weight of glass frit and from 5 to 50 % by weight of organic vehicle derived from pine oils, vegetable oils, mineral oils or low molecular petroleum fractions, based on the weight of said composition, said coating composition additionally containing from 0.5 to 15 % by weight of a selenium compound.

2. A coating composition according to claim 1, wherein said glass frit comprises a combination of metal oxides.

3. A coating composition according to claim 1, wherein said glass frit comprises a combination of metal oxides selected from the group consisting of zinc, lead, silicon, titanium, zirconium, sodium, boron, lithium, potassium, calcium, aluminium, tin, vanadium, molybdenum, magnesium, iron and manganese oxide.

4. A coating composition according to claim 1, wherein said frit comprises lead oxide, silicon dioxide and boron oxide.

5. A coating composition according to claim 1, wherein said selenium component is selected from metallic selenium, a selenide, a selenate, a sulfur-selenide complex or a metal selenide complex.

6. A coating composition according to claim 1, wherein said selenium component is a cadmium sulfur selenide pigment.

7. A coating composition according to claim 1 which contains from 50 to 82 % by weight of silver, from 2 to 22 % by weight of glass frit, from 1 to 3 % by weight of selenium component and from 7 to 22 % by weight of vehicle, based on the weight of said composition.

8. Use of a coating composition according to claim 1 for application to glass substrates.

**Revendications**

1. Matières de revêtement conductrices, contenant 45 à 90 % en poids d'argent métal sous la forme de particules, 1,5 à 25 % en poids d'une fritte de verre et 5 à 50 % en poids de supports organiques à base d'huiles de pin, d'huiles végétales, d'huiles minérales et de fractions pétrolières à faible masse moléculaire, sur la base du poids de la matière, caractérisées en ce que les matières de revêtement contiennent encore 0,5 à 15 % en poids d'un constituant sélénium.

2. Matières de revêtement selon la revendication 1, où la fritte de verre est constituée d'une combinaison d'oxydes métalliques.

3. Matières de revêtement selon la revendication 1, où la fritte de verre est constituée d'une combinaison d'oxydes métalliques sélectionnés dans le groupe comprenant les oxydes de zinc, de plomb, de silicium, de titane, de zirconium, de sodium, de bore, de lithium, de potassium, de calcium, d'aluminium, d'étain, de vanadium, de molybdène, de magnésium, de fer et de manganèse.

4. Matières de revêtement selon la revendication 1, où la fritte de verre est constituée d'oxyde de plomb, de dioxyde de silicium et d'oxyde de bore.

5. Matières de revêtement selon la revendication 1, où le constituant sélénium est du sélénium

7

**0 079 854**

métallique, un séléniure, un sélénate, un complexe au séléniure de soufre, ou un complexe au séléniure métallique.

6. Matières de revêtement selon la revendication 1, où le constituant sélénium est un pigment au séléniure de cadmium et de soufre.

7. Matières de revêtement selon la revendication 1, contenant 50 à 82 % en poids d'argent métal, 2 à 20 % en poids de fritte de verre, 1 à 3 % en poids du constituant sélénium et 7 à 22 % en poids d'une matière de support, sur la base du poids de la matière.

8. Utilisation des matières de revêtement selon la revendication 1, pour application sur des substrats de verre.